Europäisches Patentamt

(19) European Patent Office

Office européen des brevets

(11) Publication number: **0 224 828**
**A2**

## (12) EUROPEAN PATENT APPLICATION

(21) Application number: **86116236.0**

(22) Date of filing: **24.11.86**

(51) Int. Cl.⁴: **H03L 7/00** , H03L 7/18

(30) Priority: **27.11.85 JP 264891/85**

(43) Date of publication of application:
**10.06.87 Bulletin 87/24**

(84) Designated Contracting States:
**DE FR GB SE**

(71) Applicant: **HITACHI, LTD.**
**6, Kanda Surugadai 4-chome**
**Chiyoda-ku Tokyo 101(JP)**

(72) Inventor: **Kokumai, Motohiro**
**3-8-9, Hisgashikoigakubo**
**Kokubunji-shi Tokyo(JP)**

(74) Representative: **Altenburg, Udo, Dipl.-Phys. et al**
**Patent- und Rechtsanwälte**
**Bardehle-Pagenberg-Dost-Altenburg-Frohwitter & Partner Postfach 86 06 20**
**D-8000 München 86(DE)**

(54) **PLL circuit.**

(57) The PLL circuit has a configuration in which the digital PLL and the analog PLL are combined, and when the phase capture is achieved to some extent, a change-over switch terminates the phase control of the digital PLL to conduct the phase control only with the analog PLL, thereby realizing a wide capture range, a high-speed phase capture, and a small jitter of the output signal after the phase capture.

# F I G. 1

EP 0 224 828 A2

## PLL CIRCUIT

### BACKGROUND OF THE INVENTION AND RELATED ART STATESMENT

The present invention relates to a phase locked loop circuit (PLL), and in particular, to a digital PLL circuit having a digital circuit configuration.

The digital PLL circuit has characteristics that the capture range is wide and that the phase capture speed is high and hence is widely utilized in apparatuses such as a communication equipment.

In the conventional digital PLL circuit, however, a variable frequency divider is provided with a fixed range of variation in the output signal with respect to the change of the division ratio; consequently, the jitter (a variation in the phase of the output signal with respect to the phase of the input signal) cannot be reduced beyond the variation range. That is, the phase difference after the convergence thereof to some extent develops a change centered on zero with a constant jitter.

In contrast to such a prior art digital PLL circuit, there has been known a technology for overcoming the drawback as described in the JP-A-56-87939 in which the width of the step for the frequency division in the variable frequency circuit is minimized after the phase is captured.

With this technology, however, since the system is digitally operated, the jitter cannot be reduced beyond the step width of the division value, which imposes a limit to the minimization of the jitter in the digital PLL circuit.

### OBJECTS AND SUMMARY OF THE INVENTION

It is therefore an object of the present invention to provide a PLL circuit having a quite minimized jitter together with the advantages of the digital PLL circuit, namely, the wide capture range and the high phase capture speed.

According to the present invention, an analog PLL is combined with the digital PLL, so that after the phase is captured to some extent, a controller operates to terminate the phase control on the digital PLL and to operate the system only by use of the analog PLL. This enables the wide capture range and the high phase capture speed to be developed according to the digital PLL; furthermore, after the phase capture is accomplished, only the analog PLL is operated to effect the phase control, thereby considerably reducing the jitter of the output signal.

### BRIEF DESCRIPTION OF THE DRAWINGS

The present invention will be apparent from the following detailed description taken in conjunction with the accompanying drawings in which:

Fig. 1 is a configuration diagram of a PLL circuit as an embodiment of the present invention and

Fig. 2 is a timing chart illustrating the waveforms at respective positions of the PLL circuit according to the present invention.

### DETAILED DESCRIPTION OF THE PREFERRED EMBODIMENT

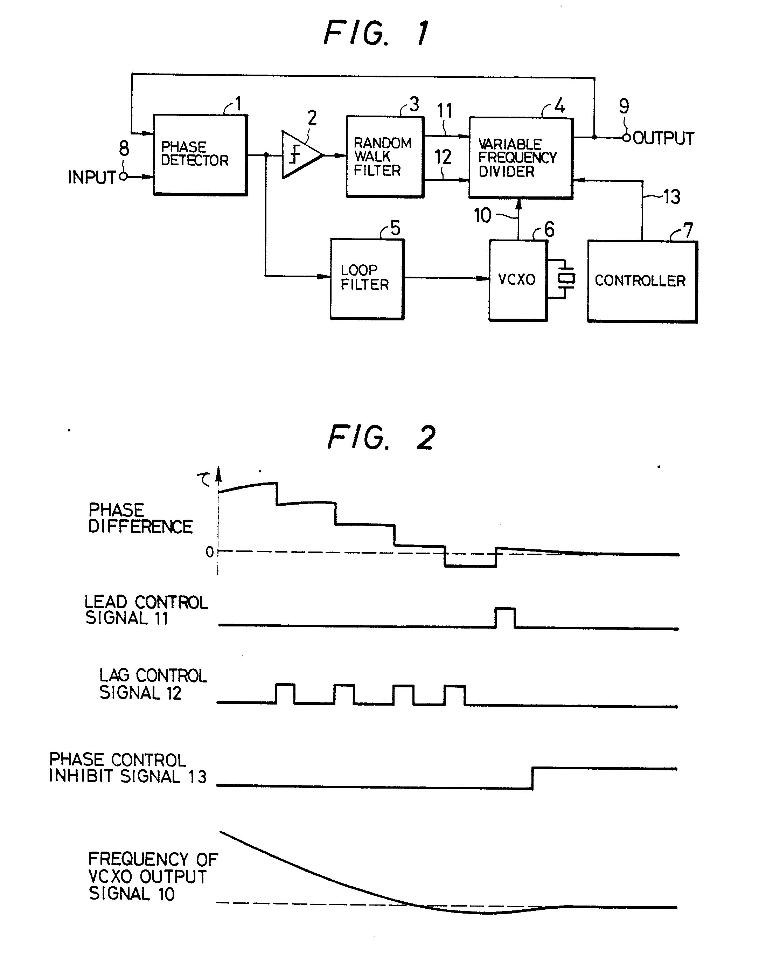

Fig. 1 is a configuration diagram of a PLL circuit as an embodiment of the present invention.

A phase detector 1 for comparing the phases of an input signal 8 and an output signal 9 achieves a three-point sampling of the input waveform with a fixed interval, for example, by use of an analog delay line and effects a predetermined arithmetic operation on the sampled values so as to detect a phase error. This method is particularly effective for the data transmission.

A comparator to digitize the phase difference signal from the phase detector 1 can be constituted, for example, from a $\mu$AF111, a $\mu$AF311, or the like of the Fairchild.

A random walk filter 3 for generating based on the signal from the comparator 2 a lead control signal 11 or a lag control signal 12 can comprise an up/down counter such as an SN74L169 of the Texas Instruments. In the random walk filter, the count up and count down operations are achieved according to the signal from the comparator 2, and when the count value reaches a preset value, the overflow or underflow takes place and the lead control signal 11 or the lag control signal 12 is outputted, and then the count value is reset to 0.

A variable frequency divider 4 for receiving an oscillation output 10 from a voltage controlled crystal oscillator (VCXO) 6 and for dividing the oscillation frequency by a division ratio corrsponding to the controll signal 11 or 12 from the random walk filter 3 so as to generate an output signal 9 can be configured by use of, for example, an SN74LS292, SN74LS294, SN74LS297, or the like of the Texas Instruments.

In addition to the digital PLL circuit described above, the system of the present invention includes a loop filter 5 and a VCXO 6 to enable the phase control of the analog PLL.

The loop filter 5 is disposed to mainly remove the noise from the phase difference signal from the phase difference detector and can be constituted from, for example, a lag lead loop filter. The lag lead loop filter has such merit as that the steady state phase error is small and a damping factor can be designed so as to operate the PLL in a stable state.

The VCXO 6 is a crystal oscillator and is suitable for the analog PLL because of a high stability.

A controller 7 for changing over between the digital PLL and the analog PLL has a function to operate when the phase capture is proceeded and the phase difference ($\tau$) between the input signal 8 and the output signal 9 is converged to some extent and is configured in various fashions. For example, this circuit may be a timer to be started in response to the input signal 8 and to be operated when a predetermined period of time is elapsed thereafter. In this case, the degree of the conversion of the phase defference $\tau$ at which the operation is initiated can be arbitrarily set according to the operation time of the timer.

That is, the timer can be implemented by use of a power on reset circuit or the like in which the timer time is set to be slightly longer than the PLL conversion time. In addition, assuming the input waveform peak appearence frequency to be f-[sec$^{-1}$], the digital PLL phase variation to be $\delta$[deg], the threshold value of the random walk filter to be R, and the initial phase error to be E deg , then the conversion time is obtained as

$$\frac{\delta}{R \times f \times E}[\,sec\,]\,.$$

Incidentally, other than such a timer, a circuit may be used which is configured to detect the phase difference from the phase difference signal from the phase detector 1 and to operate when the phase difference $\tau$ becomes equal to or less than the predetermined value. Also in this case, the degree of the minimization of the phase difference $\tau$ at which the operation is effected can be arbitrarily set according to a preset value determined in advance.

Moreover, the circuit may be configured such that by use of the lead control signal 11 and the lag control signal 12 from the random walk filter 3, the operation may be initiated by detecting the completion of a phase capture when a change-over takes place between the control signals 11 and 12.

Fig. 2 instantiates the phase difference $\tau$ between the input signal 8 and the output signal 9 of Fig. 1, the lead control signal 11, the lag control signal 12, the phase control terminate signal 13, and the oscillation output 10 from the VCXO 6.

First, an operation at the phase capture of this embodiment will be described. At the phase capture, the phase detector 1 receives as inputs the input signal 8 and the output signal 9 of the PLL to compare the phases thereof. If the phase of the output signal has a lead with respect to that of the input signal 8, a phase difference signal of the lead is generated according to the phase difference $\tau$; whereas if the phase of the output signal is delayed with respect to that of the input signal, a phase difference signal of the lag is generated according to the phase difference $\tau$. The comparator 2 receives as an input the phase difference signal from the phase detector 1 and digitizes this signal to obtain a binary value of the lead/lag, thereby outputting a lead/lag signal to the random walk filter 3. The random walk filter 3 effects the count up or count down operation according to the lead/lag signal from the comparator 2. When the count value reaches the predetermined value, the overflow or underflow is assumed and a lead control signal 11 or a lag control signal 12 is outputted at the timing of Fig. 2 depending on the overflow or underflow, and then the count value is reset to 0. The variable frequency divider 4 receives as an input an oscillation output 10 from the VCXO 6 and divides the output by a predetermined division ratio to generate an output signal 9.

Here, at the phase capture, the phase control terminate signal 13 is not being outputted from the controller 7. Consequently, the variable frequency divider 4 ordinarily increases or decreases the division ratio according to the lead control signal 11 or the lag control signal 12, respectively from the random walk filter 3, thereby modifying the phase of the output signal 9.

In addition to the operation of the digital PLL described above, the embodiment is also provided with a phase capture operation of the analog PLL. That is, in this embodiment, the oscillator supplying the oscillation output 10 to the variable frequency divider 4 includes a VCXO in which the analog PLL is configured with the phase detector 1, the loop filter 5, the VCXO 6, and the variable frequency divider 4. The phase difference signal from the phase detector 1 is inputted to the VCXO 6, which controls the oscillation frequency in the analog fashion depending on the input as shown in Fig. 2.

As described above, in this embodiment, the digital PLL and the analog PLL can be simultaneously operated to effect the phase capture at a high speed.

Next, after the phase capture is effected to some extent, the phase control terminate signal 13 is generated from the controller 7.

On receiving as an input the phase control terminate signal 13, the variable frequency divider 4 fixes the division ratio and terminates the division ratio control according to the lead control signal and the lag control signal 12 from the random walk filter 3. Consequently, the operation of the digital PLL is disabled, and the phase control is effected only with the analog PLL according to the VCXO 6. With this provision, the frequency change of the output signal 9 is small after the phase capture is conducted to some extent, and the jitter of the PLL circuit becomes very small.

Moreover, although this embodiment is configured such that the digital PLL and the analog PLL are simultaneously achieved at the phase capture, the system may be configured so that only the digital PLL is operated at the phase capture.

As described above, according to the present invention, a PLL circuit which has a wide capture range, a high phase capture speed, and a very small jitter can be implemented.

## Claims

1. A PLL circuit comprising:
a phase detector for comparing a phase of an input signal and a phase of an output signal to detect a phase difference therebetween;
an oscillator for effecting an oscillation with a frequency corresponding to the phase difference detected by said phase detector;
a variable frequency divider for conducting a division on an output from said oscillator;
changing means for changing a division ratio of said variable frequency divider according to the phase difference detected by said phase detector; and
keeping means for keeping the division ratio of said variable frequency divider to be constant when the phase difference detected by said phase detector is equal to or less than a predetermined value.

2. A PLL circuit according to claim 1 wherein said means for changing the division ratio of said variable frequency divider comprises:
a comparator for digitizing a phase difference signal from said phase detector and
a random walk filter for outputting a lead control signal or a lag control signal in response to a signal from said comparator.

3. A PLL circuit according to claim 1 wherein said means for keeping the division ratio from said variable frequency divider to be constant is a timer for terminating an operation of said changing means for changing a division ratio of said variable frequency divider according to the phase difference detected by said phase detector when a predetermined period of time is elapsed after an input signal in inputted thereto.

4. A PLL circuit comprising:
a phase detector for effecting a phase comparison between an input signal and an output signal;
a comparator for digitizing a phase difference signal from said phase detector;
a random walk filter for outputting a lead control signal or a lag control signal according to a signal from said comparator;
a variable controlled oscillator for effecting an oscillation based on the phase difference signal from said phase detector;
a variable frequency divider for dividing an oscillation frequency of said variable controlled oscillator by a division ratio according to the lead control signal or the lag control signal from said random walk filter; and
a controller for fixing the division ratio of said variable frequency divider when the phase difference signal from said phase detector is equal to or less than a predetermined value.

5. A PLL circuit according to claim 4 wherein said controller for fixing the division ratio of said variable frequency divider is a timer for terminating a transmission of the lead control signal or the lag control signal from said random walk filter to said variable frequency divider when a predetermined period of time is elapsed after an input signal in inputted thereto.

# FIG. 1

# FIG. 2